# EUROPEAN PATENT APPLICATION

(11) **EP 4 753 388 A1**
(43) Date of publication of application: **03.06.2026**
(21) Application number: 24926282.5
(22) Date of filing: 23.10.2024
(51) Int. Cl.: H05K 7/20, G05D 16/20, H01L 23/44

(54) **IMMERSION COOLING DEVICE AND METHOD**

(30) Priority: 29.08.2024 KR 20240117180
(71) Applicant: Global Standard Technology Co., Ltd, Hwaseong-si, Gyeonggi-do 18487 (KR)
(72) Inventor: CHAE, Dong Jun, Hwaseong-si, Gyeonggi-do 18459 (KR); JEONG, Seong Min, Hwaseong-si, Gyeonggi-do 18504 (KR); HEO, Jae Suk, Hwaseong-si, Gyeonggi-do 18505 (KR); KIM, Duk Jun, Seongnam-si, Gyeonggi-do 13539 (KR)
(74) Representative: Jung, Minkyu
(86) International application number: PCT/KR2024/016149
(87) International publication number: WO 2026/049120

(57) **Abstract**

An immersion cooling apparatus and method are disclosed for automatically controlling the level of a non-conductive immersion cooling fluid in a main tank by supplying and discharging the fluid via a buffer tank. In one embodiment, the apparatus may include: a main tank configured to perform immersion cooling using the non-conductive immersion cooling fluid; a buffer tank configured to store the non-conductive immersion cooling fluid; a piping unit comprising one or more pipes configured for fluid transfer between the tanks; a sensor unit comprising one or more sensors configured to measure the level of the non-conductive immersion cooling fluid; and a control unit configured to control fluid transfer between the main tank and the buffer tank based on sensor information received from the sensor unit.

## Description

### Technical Field

The present disclosure relates to immersion cooling technology, and more particularly, to an immersion cooling apparatus and method configured to automatically control the level of non-conductive immersion cooling fluid in a main tank by supplying and discharging the fluid via a buffer tank.

### Background Art

Conventionally, non-conductive immersion cooling fluid is filled into a main tank by opening the lid at the top of the tank and manually pouring the fluid. However, in such a method, the fluid may be exposed to ambient air during the filling process, which can result in fluid loss due to evaporation and may also allow external contaminants to enter the tank.

Korean Laid-Open Patent Publication No. 10-2023-0104864 discloses a cooling system for immersion cooling of electronic components.

### DETAILED DESCRIPTION OF THE INVENTION

### Technical Problem

An object of the present disclosure is to provide an immersion cooling apparatus and method capable of automatically controlling the level of a non-conductive immersion cooling fluid in a main tank by supplying and discharging the fluid via a buffer tank.

### Technical Solution

According to one aspect of the present disclosure, an immersion cooling apparatus may comprise: a main tank configured to perform immersion cooling using a non-conductive immersion cooling fluid; a buffer tank configured to store the non-conductive immersion cooling fluid; a piping unit comprising one or more pipes for fluid transfer between the main tank and the buffer tank; a sensor unit comprising one or more sensors for measuring the level of the non-conductive immersion cooling fluid stored in the main tank and the buffer tank; and a control unit configured to control fluid transfer between the main tank and the buffer tank based on sensor information received from the sensor unit.

The piping unit may include: a first pipe connected to the main tank and the buffer tank and configured to supply the non-conductive immersion cooling fluid; a second pipe connected to the main tank and the buffer tank and configured to discharge the non-conductive immersion cooling fluid; a third pipe connected to the first pipe and the second pipe and provided with a pump for supplying and discharging the non-conductive immersion cooling fluid; at least one of a fourth pipe connected to the third pipe and configured to supply the non-conductive immersion cooling fluid from an external source, and a fifth pipe connected to the third pipe and configured to discharge the non-conductive immersion cooling fluid to the outside.

The first pipe may include a first valve for the main tank and a second valve for the buffer tank, and the third pipe may be connected between the first valve and the second valve of the first pipe. The second pipe may include a third valve for the main tank and a fourth valve for the buffer tank, and the third pipe may also be connected between the third valve and the fourth valve of the second pipe.

The immersion cooling apparatus may further comprise: a first pressure pipe connected to the main tank and the buffer tank and configured to control pressure balance between the main tank and the buffer tank by using a first pressure valve; and a second pressure pipe connecting the buffer tank and an external source and configured to control internal pressure of the buffer tank by using a second pressure valve.

The control unit may open the first valve and the fourth valve and operate the pump to transfer the non-conductive immersion cooling fluid stored in the buffer tank to the main tank when the level of the non-conductive immersion cooling fluid stored in the main tank, which performs immersion cooling, is equal to or lower than a predetermined level, based on sensor information received from the sensor unit.

The control unit may open the second valve and the third valve and operate the pump to transfer the non-conductive immersion cooling fluid stored in the main tank to the buffer tank when the level of the non-conductive immersion cooling fluid stored in the main tank, which performs immersion cooling, is equal to or greater than a predetermined level, based on sensor information received from the sensor unit.

When supplying the non-conductive immersion cooling fluid stored in the buffer tank to the main tank by operating the pump, the control unit may control the first pressure valve to balance the pressure between the main tank and the buffer tank.

The sensor unit may include a first sensor to a fourth sensor provided in the main tank and a fifth sensor provided in the buffer tank, wherein the first to fourth sensors are photo sensors installed at different heights in the main tank, and the fifth sensor may be a float sensor.

The control unit may determine that the main tank is overfilled when the non-conductive immersion cooling fluid is detected by the first to fourth sensors; properly filled when detected by the second to fourth sensors; underfilled when detected by the third and fourth sensors; in a fill error state when detected by only the fourth sensor; and completely drained when not detected by any of the first to fourth sensors.

The non-conductive immersion cooling fluid may be a two-phase immersion cooling fluid, and the main tank may include a condenser configured to condense vaporized non-conductive immersion cooling fluid.

The third pipe may further include a filter disposed at an outlet of the pump.

According to one aspect of the present disclosure, an immersion cooling method may be performed by a computing device including one or more processors and a memory storing one or more programs executed by the one or more processors. The method may comprise the steps of: receiving sensor information from one or more sensors configured to measure the level of the non-conductive immersion cooling fluid stored in the main tank and the buffer tank; and controlling fluid transfer between the main tank and the buffer tank based on the sensor information, wherein the main tank may perform immersion cooling using the non-conductive immersion cooling fluid, the buffer tank may store the non-conductive immersion cooling fluid, and the main tank and the buffer tank may be connected via a piping unit comprising one or more pipes for fluid transfer between the main tank and the buffer tank.

The step of controlling fluid movement may include: opening the first valve and the fourth valve and operating the pump to transfer the non-conductive immersion cooling fluid stored in the buffer tank to the main tank when the level of the non-conductive immersion cooling fluid stored in the main tank performing immersion cooling is equal to or lower than a predetermined level based on the sensor information.

The step of controlling fluid movement may include: opening the second valve and the third valve and operating the pump to transfer the non-conductive immersion cooling fluid stored in the main tank to the buffer tank when the level of the non-conductive immersion cooling fluid stored in the main tank performing immersion cooling is equal to or greater than a predetermined level based on the sensor information.

The step of controlling fluid movement may include: controlling the first pressure valve to balance the pressure between the main tank and the buffer tank when supplying the non-conductive immersion cooling fluid stored in the buffer tank to the main tank by operating the pump.

The step of controlling fluid movement may include: determining that the main tank is in an overfilled state when the non-conductive immersion cooling fluid is detected by the first through fourth sensors; in a properly filled state when the non-conductive immersion cooling fluid is detected by the second through fourth sensors; in an underfilled state when the non-conductive immersion cooling fluid is detected by the third and fourth sensors; in a fill error state when the non-conductive immersion cooling fluid is detected only by the fourth sensor; and in a completely drained state when the non-conductive immersion cooling fluid is not detected by any of the first through fourth sensors.

### Effects of the Invention

According to the present disclosure, the level of non-conductive immersion cooling fluid can be automatically controlled by supplying and discharging the fluid, thereby preventing fluid loss and contamination.

### BRIEF DESCRIPTION OF THE DRAWINGS

FIG. 1 is a block diagram illustrating the configuration of an immersion cooling apparatus according to an embodiment of the present disclosure.
FIG. 2 is a diagram illustrating an example of the configuration of the immersion cooling apparatus according to an embodiment of the present disclosure.
FIGS. 3 to 12 are diagrams illustrating examples of operational methods of the immersion cooling apparatus according to an embodiment of the present disclosure.
FIG. 13 is a flow diagram illustrating a method of immersion cooling according to an embodiment of the present disclosure.

### BEST MODE FOR IMPLEMENTING THE INVENTION

Hereinafter, exemplary embodiments of the present disclosure will be described in detail with reference to the accompanying drawings. In the following description, well-known functions or configurations that may unnecessarily obscure the subject matter of the present disclosure will not be described in detail. In addition, the terminology used herein is defined in consideration of the functions of the present disclosure and may vary depending on the user, operator, or custom. Therefore, the definitions should be made based on the overall content of this specification.

Hereinafter, embodiments of the immersion cooling apparatus and method are described in detail with reference to the accompanying drawings.

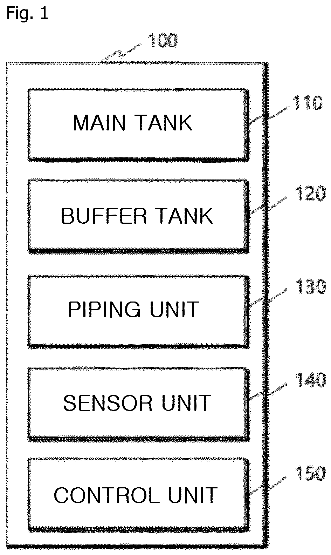

FIG. 1 is a block diagram illustrating the configuration of an immersion cooling apparatus according to an embodiment of the present disclosure.

According to one embodiment, the immersion cooling apparatus 100 may include: a main tank 110 configured to perform immersion cooling using a non-conductive immersion cooling fluid; a buffer tank 120 configured to store the non-conductive immersion cooling fluid; a piping unit 130 including one or more pipes for transferring the non-conductive immersion cooling fluid between the main tank 110 and the buffer tank 120; a sensor unit 140 including one or more sensors configured to measure the level of the non-conductive immersion cooling fluid stored in the main tank 110 and the buffer tank 120; and a control unit 150 configured to control fluid transfer between the main tank 110 and the buffer tank 120 based on sensor information received from the sensor unit 140.

In one example, immersion cooling refers to a technique for dissipating heat by submerging electronic devices, batteries, or servers in a non-conductive liquid. To enable this, a main tank 110 configured for immersion cooling may store an appropriate amount of non-conductive immersion cooling fluid, and a device to be cooled may be submerged and operated in the fluid. During the immersion cooling process, the non-conductive immersion cooling fluid may be lost due to evaporation or leakage. To address this issue, the fluid may be supplied or discharged as needed to maintain an appropriate fluid level.

According to one embodiment, the piping unit 130 may include: a first pipe 131 connected to the main tank 110 and to the buffer tank 120 and configured to supply the non-conductive immersion cooling fluid; a second pipe 132 connected to the main tank 110 and to the buffer tank 120 and configured to discharge the non-conductive immersion cooling fluid; a third pipe 133 connected to the first pipe 131 and to the second pipe 132 and equipped with a pump 181 configured to supply and discharge the non-conductive immersion cooling fluid; a fourth pipe 134 connected to the third pipe 133 and configured to receive the non-conductive immersion cooling fluid from an external source; and a fifth pipe 135 connected to the third pipe 133 and configured to discharge the non-conductive immersion cooling fluid to the outside.

In one embodiment, the first pipe 131 may include a first valve 161 for the main tank 110 and a second valve 162 for the buffer tank 120, and the third pipe 133 may be connected between the first valve 161 and the second valve 162 of the first pipe 131. For example, the control unit 150 may control the supply of the non-conductive immersion cooling fluid to the main tank 110 by opening or closing the first valve 161 and may control the supply of the fluid to the buffer tank 120 by opening or closing the second valve 162.

In one embodiment, the second pipe 132 may include a third valve 163 for the main tank 110 and a fourth valve 164 for the buffer tank 120. The third pipe 133 may be connected between the third valve 163 and the fourth valve 164 of the second pipe 132. For example, the control unit 150 may control the discharge of the non-conductive immersion cooling fluid from the main tank 110 by opening or closing the third valve 163 and may control the discharge of the non-conductive immersion cooling fluid from the buffer tank 120 by opening or closing the fourth valve 164.

In one embodiment, a first pressure pipe may be connected to both the main tank 110 and the buffer tank 120, and a first pressure valve 171 may be configured to control the pressure balance between the main tank 110 and the buffer tank 120. Additionally, a second pressure pipe may connect the buffer tank 120 and the outside, and a second pressure valve 172 may be configured to control the internal pressure of the buffer tank 120.

In one example, when the control unit 150 operates the pump to supply the non-conductive immersion cooling fluid stored in the buffer tank 120 to the main tank 110, the control unit 150 may control the first pressure valve 171 to balance the pressure between the main tank 110 and the buffer tank 120. For instance, when the amounts of non-conductive immersion cooling fluid in the main tank 110 and the buffer tank 120 change, the internal pressure inside the sealed tanks may also vary. In this case, the control unit 150 may control the first pressure valve 171 and the second pressure valve 172 to regulate the internal pressure of the tanks.

According to one embodiment, the sensor unit 140 may include at least one of a first sensor 141 to a fourth sensor 144 provided in the main tank 110 and a fifth sensor 145 provided in the buffer tank 120. For example, the first to fourth sensors 141-144 may be photo sensors and may be disposed at different heights within the main tank 110. The fifth sensor 145 may be a float sensor.

According to one embodiment, the control unit 150 may determine that the main tank 110 is overfilled when the non-conductive immersion cooling fluid is detected by the first to fourth sensors 141-144; properly filled when detected by the second to fourth sensors 142-144; underfilled when detected by the third and fourth sensors 143 and 144; in a fill error state when detected only by the fourth sensor 144; and fully drained when not detected by any of the first to fourth sensors 141-144.

For example, a fill error may correspond to a fluid level at which the non-conductive immersion cooling fluid cannot effectively perform its cooling function, which may result in overheating of the device. Accordingly, when the main tank is determined to be in a fill error, the control unit 150 may stop the operation of the entire system.

According to one embodiment, when the level of the non-conductive immersion cooling fluid stored in the main tank 110, which performs immersion cooling, is equal to or lower than a predetermined threshold based on the sensor information received from the sensor unit 140, the control unit 150 may open the first valve 161 and the fourth valve 164 and operate the pump 181 to transfer the non-conductive immersion cooling fluid stored in the buffer tank 120 to the main tank 110.

### MODE FOR IMPLEMENTING THE INVENTION

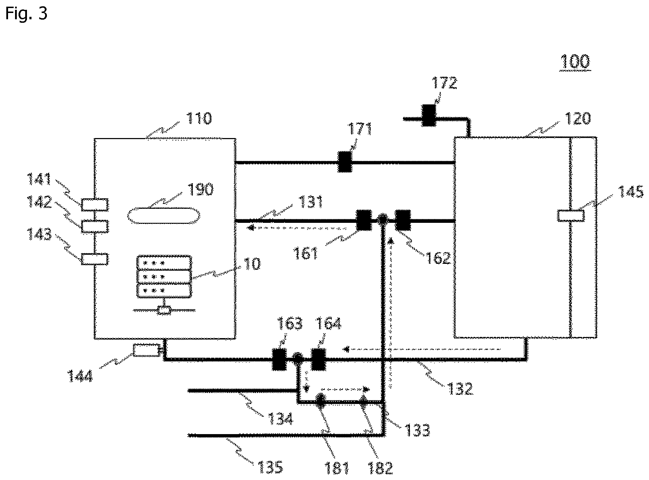

Referring to FIG. 3, the control unit 150 may supply the non-conductive immersion cooling fluid stored in the buffer tank 120 to the main tank 110 without external supply. For example, the control unit 150 may open a first valve 161 for filling the main tank and a fourth valve 164 for discharging the buffer tank, control the non-conductive immersion cooling fluid to move from the buffer tank 120 to the main tank 110, and operate the pump 181. In addition, the control unit 150 may control a first pressure valve 171 for pressure balance to be opened so that the pressure of the main tank 110 and the buffer tank 120 is maintained at an optimum value.

In one example, the control unit 150 may identify the level of the non-conductive immersion cooling fluid based on sensor information from the sensor unit 140. For instance, when the non-conductive immersion cooling fluid is supplied to the main tank 110 and reaches a reference level, the control unit 150 may stop operation of the pump 181, and close the first valve 161, the fourth valve 164, and the first pressure valve 171 to complete the fluid filling.

According to an embodiment, when the level of the non-conductive immersion cooling fluid stored in the main tank 110 for immersion cooling exceeds a predetermined level based on the sensor information received from the sensor unit 140, the control unit 150 may open the second valve 162 and the third valve 163, and operate the pump 181 to transfer the fluid from the main tank 110 to the buffer tank 120.

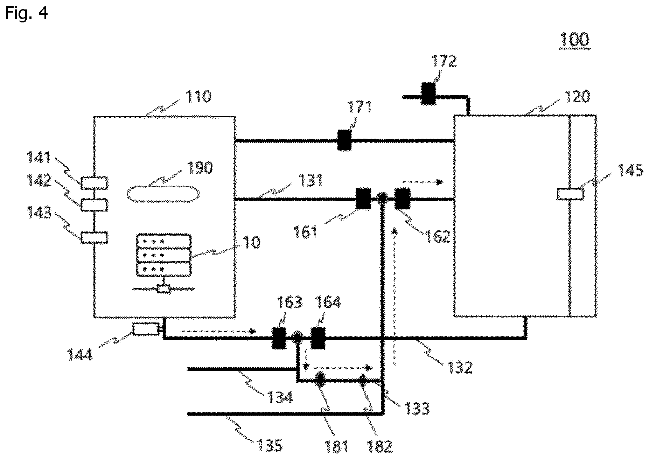

Referring to FIG. 4, the control unit 150 may discharge the non-conductive immersion cooling fluid stored in the main tank 110 to the buffer tank. For example, the control unit 150 may open a third valve 163 for discharging the main tank and a second valve 162 for filling the buffer tank, control the non-conductive immersion cooling fluid to move from the main tank 110 to the buffer tank 120, and operate the pump 181. Additionally, the control unit 150 may control a first pressure valve 171 for pressure balance to be opened so that the pressure of the main tank 110 and the buffer tank 120 is maintained at an optimum level.

In one example, when the non-conductive immersion cooling fluid is discharged from the main tank 110 and reaches a reference level, the control unit 150 may stop operation of the pump 181, and close the third valve 163, the second valve 162, and the first pressure valve 171 to complete the fluid discharge.

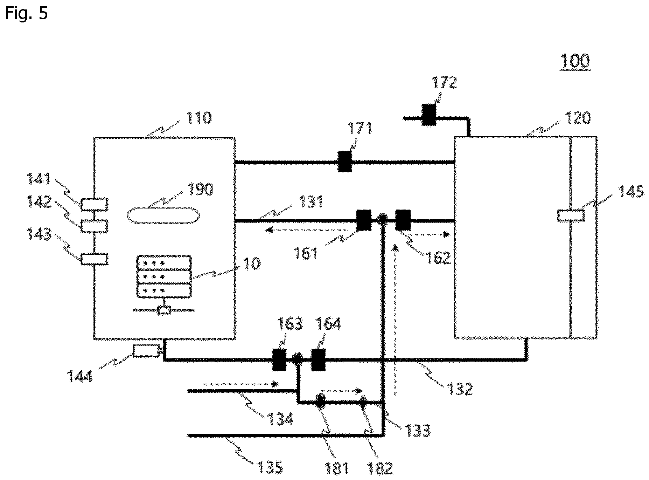

In one example, the control unit 150 may simultaneously fill the main tank 110 and the buffer tank 120 with non-conductive immersion cooling fluid supplied from an external source. Referring to FIG. 5, the control unit 150 may open a first valve 161 and a second valve 162 to control the supply of non-conductive immersion cooling fluid to the main tank and the buffer tank via a third valve 163 connected to an external filling port, and operate the pump 181. Additionally, the control unit 150 may open a first pressure valve 171 and a second pressure valve 172 for air purge, to maintain the pressure of the main tank 110 and the buffer tank 120 at a predetermined optimal level.

In one example, the control unit 150 may perform control based on sensors installed in each tank. For instance, during the filling process, the control unit 150 may use sensor values from a second sensor 142 to monitor the main tank and from a fifth sensor 145 to monitor the buffer tank. For convenience of explanation, a sensor status that meets a predetermined condition may be indicated as 'O' and a status that does not meet the condition may be indicated as 'X'.

In one example, when the main tank reaches the reference level (O) and the buffer tank does not (X), the control unit 150 may close the first valve 161 and the first pressure valve 171 to stop filling the main tank while continuing to fill the buffer tank. Then, when both the main tank and the buffer tank reach their respective reference levels (O), the control unit 150 may stop the operation of the pump 181 and close the second valve 162 and the second pressure valve 172 to stop the fluid filling process.

In another example, when the main tank has not reached the reference level (X) and the buffer tank has (O), the control unit 150 may close the second valve 162 to stop filling the buffer tank while continuing to fill the main tank. Then, when both the main tank and the buffer tank reach their respective reference levels (O), the control unit 150 may stop the operation of the pump 181 and close the first valve 161, the first pressure valve 171, and the second pressure valve 172 to stop the fluid filling process.

In one example, the control unit 150 may simultaneously discharge the non-conductive immersion cooling fluid stored in the main tank 110 and the buffer tank 120 through a fifth pipe 135, which is a discharge port connected to the outside.

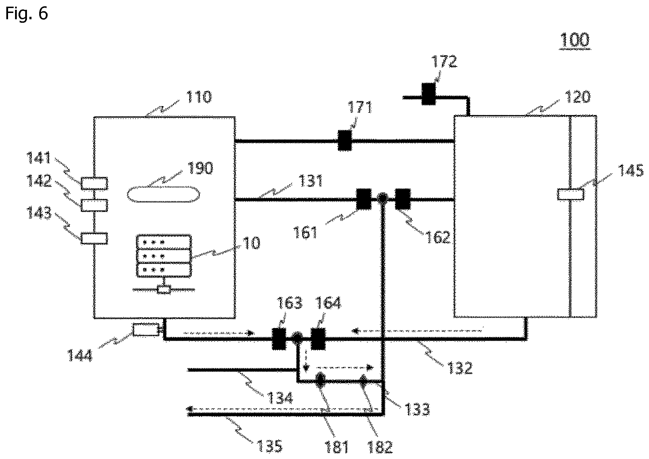

Referring to FIG. 6, the control unit 150 may open the third valve 163 and the fourth valve 164 related to fluid discharge to allow the non-conductive immersion cooling fluid to flow from the main tank and the buffer tank toward the discharge port, and may operate the pump 181. In addition, the control unit 150 may open the first pressure valve 171 and the second pressure valve 172 to maintain the pressure of the main tank and the buffer tank at a predetermined optimal value.

In one example, the control unit 150 may confirm, based on sensor information, that the non-conductive immersion cooling fluid has been discharged from the main tank and the buffer tank to their respective reference levels. For instance, the control unit 150 may operate based on sensor information from the fourth sensor 144 installed in the main tank and the fifth sensor 145 installed in the buffer tank.

In another example, if the main tank has reached the reference level (O) while the buffer tank has not (X), the control unit 150 may close the third valve 163 and the first pressure valve 171 to stop the discharge from the main tank while continuing to discharge from the buffer tank. Then, when both the main tank and the buffer tank reach their respective reference levels (O), the control unit 150 may stop the operation of the pump 181 and close the fourth valve 164 and the second pressure valve 172 to stop the fluid discharge.

In another example, if the main tank has not reached the reference level (X) while the buffer tank has (O), the control unit 150 may close the fourth valve 164 to stop the discharge from the buffer tank and continue the discharge from the main tank. Then, when both the main tank and the buffer tank reach their respective reference levels (O), the control unit 150 may stop the operation of the pump 181 and close the third valve 163, the first pressure valve 171, and the second pressure valve 172 to stop the fluid discharge.

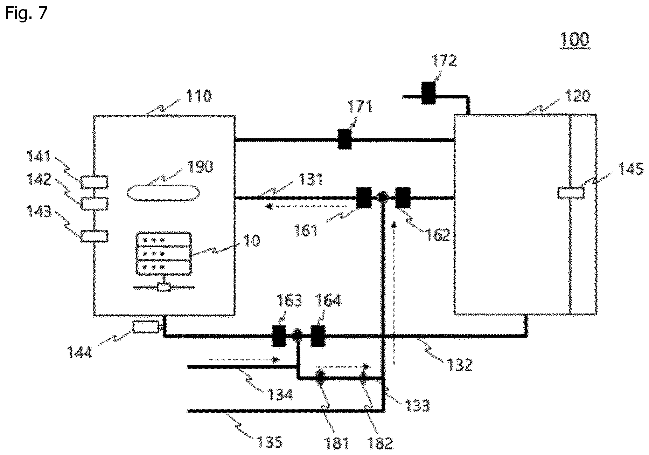

According to one example, the control unit 150 may charge the main tank 110 using an externally connected filling port. Referring to FIG. 7, the control unit 150 may open the first valve 161 to allow the non-conductive immersion cooling fluid to flow from the filling port into the main tank, and may operate the pump 181. The control unit 150 may also open the first pressure valve 171 and the second pressure valve 172 to maintain the pressure within the main tank at a predetermined optimal level. When the fluid has been supplied to the main tank and reaches the reference level, the control unit 150 may stop the operation of the pump 181 and close the first valve 161, the first pressure valve 171, and the second pressure valve 172 to stop the fluid filling process.

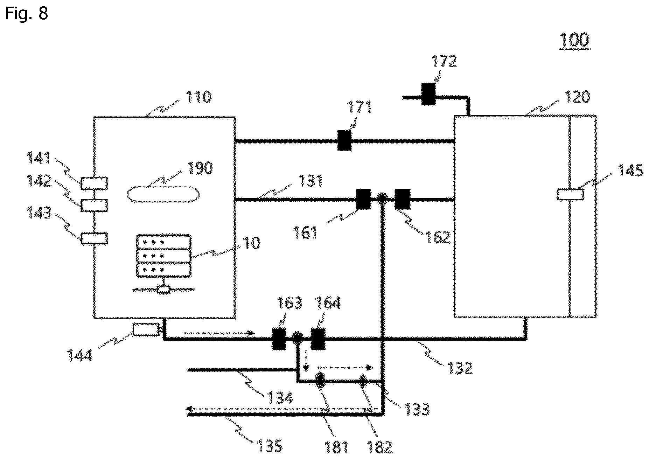

According to one example, the control unit 150 may discharge the non-conductive immersion cooling fluid from the main tank 110 using an externally connected discharge port. Referring to FIG. 8, the control unit 150 may open the third valve 163 to allow the fluid to flow from the main tank to the discharge port and operate the pump 181. In addition, the control unit 150 may open the first pressure valve 171 and the second pressure valve 172 to maintain the pressure in the main tank at a predetermined optimal level. When the fluid has been discharged from the main tank and the reference level is reached such that the non-conductive immersion cooling fluid is no longer detected by the fourth sensor 144, the control unit 150 may stop the operation of the pump 181 and close the third valve 163, the first pressure valve 171, and the second pressure valve 172 to stop the fluid discharge.

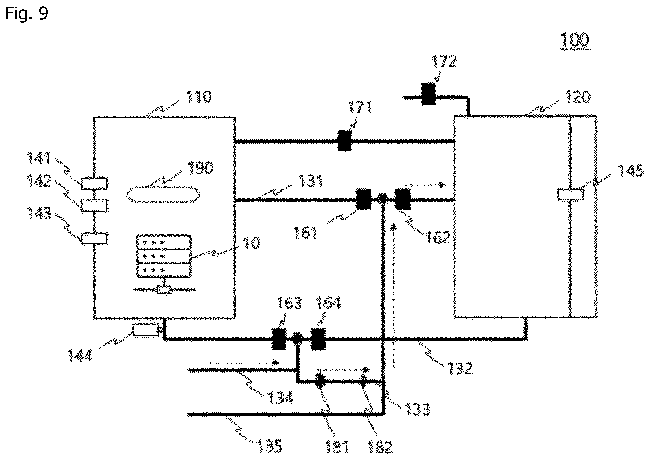

According to one example, the control unit 150 may supply non-conductive immersion cooling fluid to the buffer tank 120 using an externally connected filling port. Referring to FIG. 9, the control unit 150 may open the second valve 162 to allow the non-conductive immersion cooling fluid to flow from the filling port to the buffer tank and may operate the pump 181. The control unit 150 may also open the second pressure valve 172 to maintain the pressure in the buffer tank at a predetermined optimal level. When the fluid has been supplied to the buffer tank and reaches the reference level, the control unit 150 may stop the operation of the pump 181 based on the sensor information from the fifth sensor 145 and may close the second valve 162 and the second pressure valve 172 to stop the fluid filling.

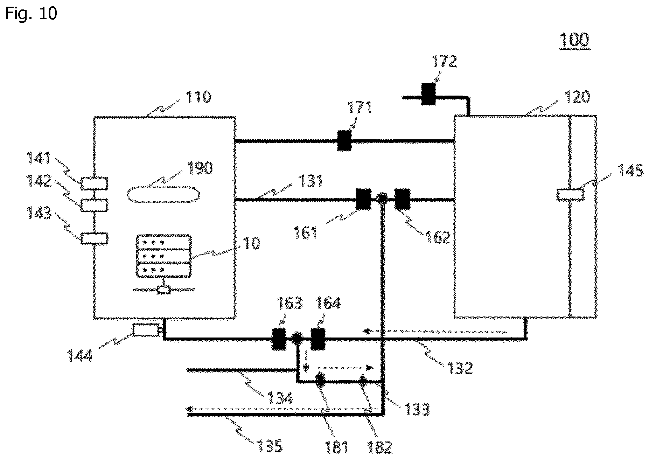

According to one example, the control unit 150 may discharge the non-conductive immersion cooling fluid from the buffer tank 120 using an externally connected discharge port. Referring to FIG. 10, the control unit 150 may open the fourth valve 164 to allow the fluid to flow from the buffer tank to the discharge port and may operate the pump 181. In addition, the control unit 150 may open the second pressure valve 172 to maintain the pressure in the buffer tank at a predetermined optimal level. When the fluid has been discharged from the buffer tank and reaches the reference level, the control unit 150 may stop the operation of the pump 181 based on the sensor information from the fifth sensor 145 and may close the fourth valve 164 and the second pressure valve 172 to stop the fluid discharge.

According to one example, the third pipe 133 may further include a filter 182 at the output end of the pump 181. For example, the filter may perform the functions of removing foreign substances, hydrocarbons, or moisture.

In one example, the filter typically has a porous structure and may be selected based on factors such as particle size, shape, and concentration. The filter may comprise a filter medium including a support structure such as a metal mesh, and a filter housing, which is made of a metal material that prevents electrostatic buildup, enabling the fluid to pass evenly through the filter medium during filtration and providing external protection. The housing may be sealed with sealing materials such as silicone, NBR, or EPDM to prevent external leakage.

For example, the removal of foreign substances is based on the principle of physically blocking fine solid particles that drift along with the fluid. Particles larger than the voids of the filter medium cannot pass through and may be trapped on the surface or inside the filter. Therefore, the filter must have extremely fine voids, and may be made of materials with multilayer structures and high chemical resistance, such as polypropylene, or cellulose materials that can be made by weaving fibers.

For example, referring to the removal of organic compounds, substances such as elastomers, PVC insulators, foam, adhesives, and soldering flux may release nonreactive hydrocarbons (e.g., DOP, PDMS) and chemically activated hydrocarbons (e.g., soldering flux). To remove these, activated carbon may be used. Activated carbon has a porous structure, and organic compounds and non-polar molecules (e.g., DOP, PDMS) may enter the pores and be adsorbed onto the surface of the activated carbon via weak intermolecular interactions, such as Van der Waals forces. Chemically activated hydrocarbon molecules (VOCs) may also be adsorbed onto the surface of the activated carbon via weak chemical bonds.

For example, to remove moisture, filters made of silica gel or activated alumina may be used. Activated alumina has a relatively more uniform and finer pore structure than silica gel and provides superior adsorption performance under low moisture solubility conditions, along with high chemical stability. Activated alumina is a porous medium made by activating aluminum oxide (Al₂O₃) and is mainly used to adsorb polar compounds and moisture. Filters have complementary characteristics, and a combination of them enables comprehensive contaminant removal. However, proper filter control according to the operating conditions is required.

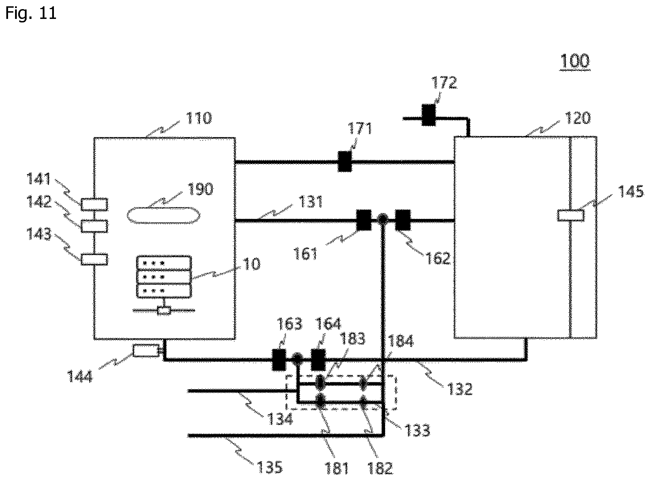

In one example, the piping system may be configured with redundancy as a countermeasure against pump failure. For instance, in a single-structure configuration, if the pump 181 fails, this may be a single point of failure (SPOF), which disables all functions. To address this, as shown in FIG. 11, the third pipe 163 may be configured with redundancy. In this case, the reason why the channels respectively include filters (182, 183) is that they allow continued operation even during filter replacement.

In one example, the sensors 141 to 144 installed in the main tank 110 may be optical level sensors. These may be installed on pipes made of transparent materials and operate by measuring changes in the amount of light reaching a receiver from a transmitter, based on the scattering or absorption of light depending on the presence or absence of liquid. Therefore, the sensors can only detect whether liquid is present at their positions, and multiple sensors positioned at different heights are required to determine the level of the fluid.

The sensor 145 provided in the buffer tank 120 may be an analog output float level sensor, in which a floating element that floats on the surface of the fluid moves up and down depending on the fluid level, and this movement is converted into an analog signal by a mechanical or electronic mechanism in the sensor to continuously detect changes in the fluid level. This allows for precise level control; however, the floating element may be affected by fluid flow, and since the floating element moves mechanically due to buoyancy, there is a possibility of foreign matter being generated due to friction. In addition, it may occupy more space compared to an optical level sensor.

According to one embodiment, the non-conductive immersion cooling fluid may be a two-phase immersion cooling fluid, and the main tank 110 may include a condenser configured to condense the vaporized non-conductive immersion cooling fluid.

For example, in a two-phase immersion cooling apparatus utilizing phase change, vapor bubbles generated at the surface of an electronic device (solid-liquid interface) separate from the interface once they reach a certain size and rise to the liquid surface due to the difference in density of the fluid. Therefore, if a float level sensor is installed in the main tank, the generated vapor bubbles can randomly ascend to the free surface causing surface turbulence, which leads to irregular fluctuations in fluid level and undermines the measurement reliability of the float level sensor. To suppress the effects of such turbulence, a guide tube may need to be installed around the float. In contrast, if an optical level sensor is installed at a point where level fluctuations due to surface turbulence cannot reach, their influence can be ignored. Since the main tank is where the electronic device is installed and is subject to greater temperature variations than the buffer tank, the optical level sensor is more effective in the main tank.

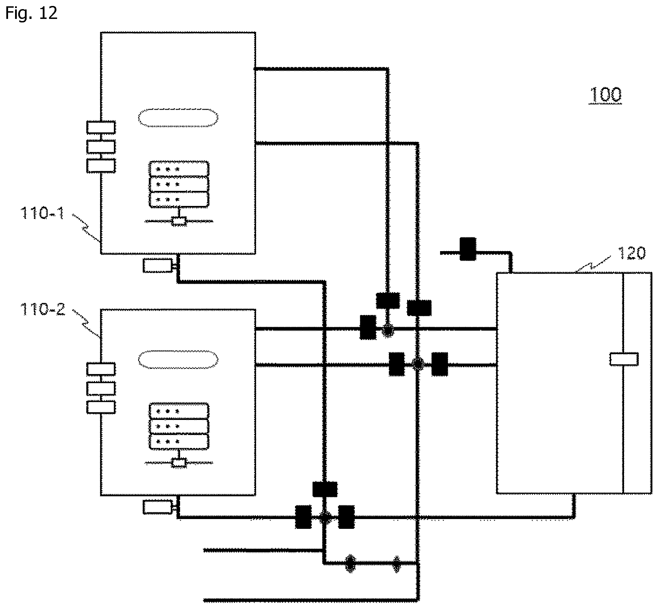

According to one example, two or more main tanks may be connected to a single buffer tank. Referring to FIG. 12, two main tanks 110-1 and 110-2 may be connected to a single buffer tank 120, and each of them may be controlled in a manner consistent with the examples described above.

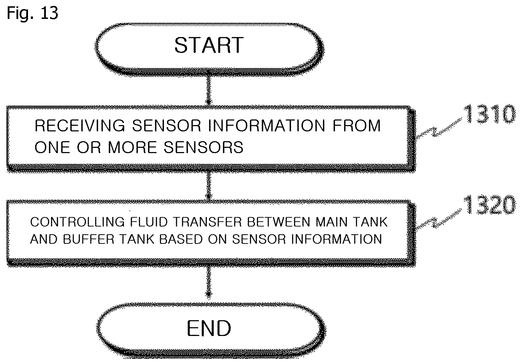

FIG. 13 illustrates a flow diagram of an immersion cooling method according to one embodiment.

In one example, the immersion cooling apparatus may be a computing device comprising one or more processors and a memory storing one or more programs executed by the one or more processors.

According to one embodiment, the immersion cooling apparatus may receive sensor information (1310) from one or more sensors configured to measure the level of the non-conductive immersion cooling fluid stored in the main tank and the buffer tank, and control fluid transfer between the main tank and the buffer tank based on the sensor information (1320).

Through this process, the main tank may perform immersion cooling using the non-conductive immersion cooling fluid, and the buffer tank may store the non-conductive immersion cooling fluid. Additionally, the main tank and the buffer tank may be connected via a piping unit that includes one or more pipes for fluid transfer between the two tanks.

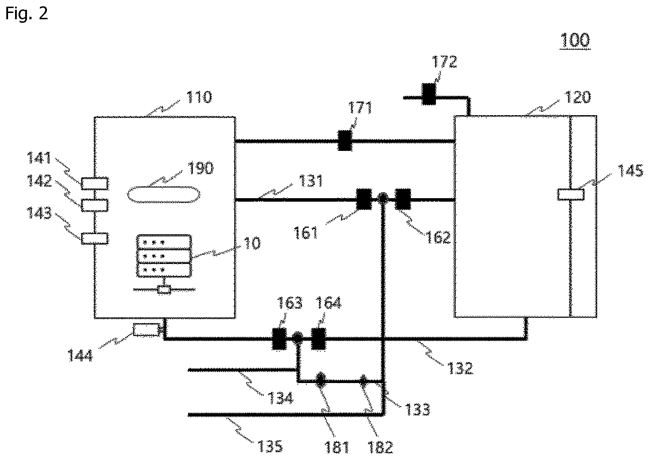

Redundant descriptions of the embodiment illustrated in FIG. 13 that overlap with the embodiments described with reference to FIGS. 1 through 12 are omitted.

In addition, the embodiments of the present disclosure are not limited to two-phase immersion cooling apparatuses, but may also be applied to single-phase immersion cooling apparatuses.

One aspect of the present disclosure may be implemented as a computer-readable recording medium having stored thereon computer-readable code. The code and code segments for implementing the above-described program may be readily derived by those skilled in the art of computer programming. The computer-readable recording medium may include all types of storage devices capable of storing data that can be read by a computer system. Examples of computer-readable recording media include ROM, RAM, CD-ROM, magnetic tapes, floppy disks, and optical disks. In addition, the computer-readable recording medium may be distributed across network-connected computer systems, such that the code is written and executed in a distributed manner.

The preferred embodiments of the present disclosure have been described above. However, those skilled in the art will appreciate that various modifications may be made without departing from the essential features of the present disclosure. Therefore, the scope of the present disclosure should not be limited to the above-described embodiments, but should be interpreted to include various embodiments within the scope equivalent to the claims.

### INDUSTRIAL APPLICABILITY

The present disclosure is industrially applicable to the immersion cooling industry.

## Claims

1. An immersion cooling apparatus comprising:
a main tank configured to perform immersion cooling using a non-conductive immersion cooling fluid;
a buffer tank configured to store the non-conductive immersion cooling fluid;
a piping unit comprising one or more pipes configured for fluid transfer between the main tank and the buffer tank;
a sensor unit comprising one or more sensors configured to measure the level of the non-conductive immersion cooling fluid stored in the main tank and the buffer tank; and
a control unit configured to control fluid transfer between the main tank and the buffer tank based on sensor information from the sensor unit.

2. The immersion cooling apparatus according to claim 1,
wherein the piping unit comprises at least one of:
a first pipe connected to the main tank and the buffer tank, and configured to supply the non-conductive immersion cooling fluid;
a second pipe connected to the main tank and the buffer tank, and configured to discharge the non-conductive immersion cooling fluid;
a third pipe connected to the first pipe and the second pipe and comprising a pump configured to supply and discharge the non-conductive immersion cooling fluid;
a fourth pipe connected to the third pipe and configured to supply the non-conductive immersion cooling fluid from an external source; and
a fifth pipe connected to the third pipe and configured to discharge the non-conductive immersion cooling fluid to the outside.

3. The immersion cooling apparatus according to claim 2,
wherein the first pipe comprises a first valve for the main tank and a second valve for the buffer tank, and the third pipe is connected between the first valve and the second valve of the first pipe;
the second pipe comprises a third valve for the main tank and a fourth valve for the buffer tank, and the third pipe is connected between the third valve and the fourth valve of the second pipe.

4. The immersion cooling apparatus according to claim 3,
further comprising:
a first pressure pipe connected to the main tank and the buffer tank and configured to control pressure balance between the main tank and the buffer tank via a first pressure valve; and
a second pressure pipe connecting the buffer tank and the outside and configured to control the internal pressure of the buffer tank via a second pressure valve.

5. The immersion cooling apparatus according to claim 4,
wherein the control unit, based on sensor information received from the sensor unit,
opens the first valve and the fourth valve when the level of the non-conductive immersion cooling fluid stored in the main tank performing immersion cooling is equal to or below a predetermined level, and
operates the pump to transfer the non-conductive immersion cooling fluid stored in the buffer tank to the main tank.

6. The immersion cooling apparatus according to claim 4,
wherein the control unit, based on sensor information received from the sensor unit,
opens the second valve and the third valve when the level of the non-conductive immersion cooling fluid stored in the main tank performing immersion cooling is equal to or above a predetermined level, and
operates the pump to transfer the non-conductive immersion cooling fluid from the main tank to the buffer tank.

7. The immersion cooling apparatus according to claim 5,
wherein the control unit controls the first pressure valve to balance the pressure between the main tank and the buffer tank when the pump is operated to supply the non-conductive immersion cooling fluid stored in the buffer tank to the main tank.

8. The immersion cooling apparatus according to claim 1,
wherein the sensor unit comprises first to fourth sensors provided in the main tank and a fifth sensor provided in the buffer tank, wherein the first to fourth sensors are photo sensors disposed at different heights in the main tank, and the fifth sensor is a float sensor.

9. The immersion cooling apparatus according to claim 8,
wherein the control unit determines that the main tank is
overfilled when the non-conductive immersion cooling fluid is detected by the first to fourth sensors,
properly filled when the fluid is detected by the second to fourth sensors,
underfilled when the fluid is detected by the third and fourth sensors,
in a fill error when the fluid is detected only by the fourth sensor,
and fully discharged when the fluid is not detected by any of the first to fourth sensors.

10. The immersion cooling apparatus according to claim 1,
wherein the main tank includes a condenser configured to condense vaporized non-conductive immersion cooling fluid.

11. The immersion cooling apparatus according to claim 2,
wherein the third pipe further includes a filter at the outlet of the pump.

12. An immersion cooling method, which is performed in a computing device comprising at least one processor, and a memory storing one or more programs executed by the at least one processor, comprising the steps of:
receiving sensor information from one or more sensors configured to measure the level of a non-conductive immersion cooling fluid stored in a main tank and a buffer tank; and
controlling fluid transfer between the main tank and the buffer tank based on the sensor information,
wherein the main tank performs immersion cooling using the non-conductive immersion cooling fluid,
the buffer tank stores the non-conductive immersion cooling fluid,
and the main tank and the buffer tank are connected via a piping unit including one or more pipes for fluid transfer between the main tank and the buffer tank.

13. The method according to claim 12,
wherein the piping unit comprises at least one of:
a first pipe connected to the main tank and the buffer tank, and configured to supply the non-conductive immersion cooling fluid;
a second pipe connected to the main tank and the buffer tank, and configured to discharge the non-conductive immersion cooling fluid;
a third pipe connected to the first pipe and the second pipe and provided with a pump configured to supply and discharge the non-conductive immersion cooling fluid;
a fourth pipe connected to the third pipe and configured to supply the non-conductive immersion cooling fluid from an external source; and
a fifth pipe connected to the third pipe and configured to discharge the non-conductive immersion cooling fluid to the outside.

14. The method according to claim 13,
wherein the first pipe includes a first valve for the main tank and a second valve for the buffer tank, and the third pipe is connected between the first valve and the second valve of the first pipe, and
wherein the second pipe includes a third valve for the main tank and a fourth valve for the buffer tank, and the third pipe is connected between the third valve and the fourth valve of the second pipe.

15. The method according to claim 14,
further comprising:
a first pressure pipe connected to the main tank and the buffer tank and configured to control pressure balance between the main tank and the buffer tank using a first pressure valve; and
a second pressure pipe connecting the buffer tank and the outside and configured to control the internal pressure of the buffer tank using a second pressure valve.

16. The method according to claim 15,
wherein the step of controlling fluid transfer comprises, when the level of the non-conductive immersion cooling fluid stored in the main tank that performs immersion cooling is equal to or lower than a predetermined level based on the sensor information, opening the first valve and the fourth valve, and operating the pump to transfer the non-conductive immersion cooling fluid stored in the buffer tank to the main tank.

17. The method according to claim 15,
wherein the step of controlling fluid transfer comprises, when the level of the non-conductive immersion cooling fluid stored in the main tank that performs immersion cooling is equal to or higher than a predetermined level based on the sensor information, opening the second valve and the third valve, and operating the pump to transfer the non-conductive immersion cooling fluid stored in the main tank to the buffer tank.

18. The method according to claim 16,
wherein the step of controlling fluid transfer comprises, when the pump is operated to supply the non-conductive immersion cooling fluid stored in the buffer tank to the main tank, controlling the first pressure valve to balance the pressure between the main tank and the buffer tank.

19. The method according to claim 12, wherein the one or more sensors comprise first to fourth sensors provided in the main tank, and a fifth sensor provided in the buffer tank, wherein the first to fourth sensors are photo sensors and are installed at different heights in the main tank, and the fifth sensor is a float sensor.

20. The method according to claim 19,
wherein the step of controlling fluid transfer comprises determining that the main tank is:
overfilled when the non-conductive immersion cooling fluid is detected by the first to fourth sensors,
properly filled when the fluid is detected by the second to fourth sensors,
underfilled when the fluid is detected by the third and fourth sensors,
in a fill error when the fluid is detected only by the fourth sensor, and
fully discharged when the fluid is not detected by any of the first to fourth sensors.

21. The method according to claim 12,
wherein the main tank includes a condenser for condensing vaporized non-conductive immersion cooling fluid.

22. The method according to claim 13,
wherein the third pipe further includes a filter at an output end of the pump.
